(19) Europäisches Patentamt
European Patent Office
Office européen des brevets

(11) **EP 1 653 790 B1**

(12) **EUROPÄISCHE PATENTSCHRIFT**

(45) Veröffentlichungstag und Bekanntmachung des Hinweises auf die Patenterteilung:
**04.04.2007 Patentblatt 2007/14**

(51) Int Cl.:
*H05K 7/20* (2006.01)    *B41J 32/00* (2006.01)
*G07B 17/00* (2006.01)

(21) Anmeldenummer: **05020742.2**

(22) Anmeldetag: **23.09.2005**

(54) **Sicherheitsgehäuse mit Lüftungsöffnungen**

Security case with venting openings

Boîtier de sécurité avec ouvertures de ventilation

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **27.10.2004 DE 202004016611 U**

(43) Veröffentlichungstag der Anmeldung:
**03.05.2006 Patentblatt 2006/18**

(73) Patentinhaber: **Francotyp-Postalia GmbH 16547 Birkenwerder (DE)**

(72) Erfinder: **Wölm, Dieter 15806 Gross Schulzendorf (DE)**

(56) Entgegenhaltungen:
FR-A- 2 726 636    US-A- 5 931 002
US-A1- 2003 112 314

**Beschreibung**

Die Erfindung betrifft ein Sicherheitsgehäuse mit Lüftungsöffnungen zur Luftzuführung an eine Wärmequelle im Innenraum eines Gerätes gemäß dem Oberbegriff des Anspruchs 1. Das Gerät benutzt eine Konvektion von Luft zur Wärmeabführung von der Wärmequelle und kommt ohne Lüfter aus. Die Erfindung kommt in Frankiermaschinen und in ähnlichen druckenden Buchungs- oder Postverarbeitungsgeräten zum Einsatz.

Aus dem US 4.767.228, US 4.886.384 bzw. EP 189 984 B1 ist eine Thermotransfer-Frankiermaschine bekannt, wie sie in ähnlicher Form bei modernen Thermotransfer-Frankiermaschinen vom Typ T1000 bzw. Optimal der Herstellerin Francotyp Postalia Beteiligungs AG eingesetzt wird.

Dort werden bereits Lüftungsschlitze auf der Rückseite des Sicherheitsgehäuses vorgesehen, die jedoch Blicke auf die darunter liegende Leiterplatte nicht versperren. Die Wärmeabführung geschieht durch Konvektion ohne Zwangslüftung. Eine gezielte Luftleitung ist jedoch nicht möglich.

Aus der US 6,739,717 B2 (stammt von FP) ist ein Sicherheitschassis innerhalb eines Sicherheitsgehäuses der Frankiermaschine Ultimail bekannt. Eine zwangsweise Luftführung mittels Lüfter führt zum Luftaustritt durch Lüftungsöffnungen auf der Rückseite des Sicherheitsgehäuses, welches nicht extra gegen ein Eindringen mittels eines Werkzeuges geschützt ist. Jedoch werden Öffnungen im Sicherheitschassis beschrieben, die ein Eindringen von Werkzeugen in den von zwei Chassisschalen eingeschlossenen Sicherheitsbereich unmöglich machen.

Es ist Aufgabe, die Belüftungsöffnungen in einem Sicherheitsgehäuse zum Leiten eines Luftstromes an die Wärmequelle auszubilden, wobei die Wärmeabführung durch Konvektion ohne Zwangslüftung erfolgt. Die Belüftungsöffnungen sollen gleichzeitig gegen Eindringen mit Werkzeugen in den Sicherheitsbereich geschützt sein. Das Sicherheitsgehäuse soll sich durch eine leichte und kostengünstige Fertigbarkeit auszeichnen.

Die Aufgabe wird mit den Merkmalen der Anordnung nach dem Schutzanspruch 1 gelöst.

Das Sicherheitsgehäuse weist Lüftungsöffnungen zur Luftzuführung an eine Wärmequelle im Innenraum eines Gerätes auf, in welchem eine Konvektion von Luft zur Wärmeabführung von der Wärmequelle erfolgt. Erste Luftführungselemente auf der Innenseite des Sicherheitsgehäuses sind an wenigstens einer ersten Seite jeder der Lüftungsöffnungen angeordnet und so geformt, dass letztere wenigstens teilweise überdeckt werden. Ein entfernbares Sicherheitsgehäuseteil ist mit zweiten Luftführungselementen versehen und im Innenraum des Gerätes angeordnet, wobei die zweiten Luftführungselemente an einer jeweils der vorgenannten ersten Seite jeder der Lüftungsöffnungen gegenüberliegenden zweiten Seite im Abstand angeordnet und so geformt sind, dass sie die Lüftungsöffnungen des Sicherheitsgehäuses und ersten Luftführungselemente wenigstens soweit überdecken, dass im Bereich der ersten und zweiten Luftführungselemente eine ungeradlinige Luftführung gewährleistet wird. Damit wird ein geradliniges Einführen von Werkzeugen durch die Lüftungsöffnungen und damit ein Zugriff auf einen Sicherheitsbereich im Innenraum des Sicherheitsgehäuses verhindert.

Die Lüftungsöffnungen können eine Langloch- oder Viereckform aufweisen, so dass zwei der der jeweils gegenüberliegenden parallelen Seiten näher voneinander beabstandet sind. An einer der zuletzt genannten beiden Seiten sind erste Luftführungselemente auf der Innenseite des Sicherheitsgehäuses angeordnet. Aus der Richtung einer der beiden anderen jeweils gegenüberliegenden parallelen Seiten, die aber weiter voneinander beabstandet sind, kann das Sicherheitsgehäuseteil gesteckt bzw. entfernt werden, ohne dass dessen zweite Luftführungselemente mit den ersten Luftführungselementen kollidieren.

Die ersten Luftführungselemente auf der Innenseite des Sicherheitsgehäuses können eine Rippenform aufweisen, die in den Innenraum des Gerätes ragen. Vorzugsweise weisen die zweiten Luftführungselemente eine Haubenform auf, um die Rippen zu überdecken, wenn das Sicherheitsgehäuseteil in das Sicherheitsgehäuse gesteckt bzw. montiert ist.

Vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:

Fig. 1a,     perspektivische Ansicht von vorn und rechts oben einer Thermotransfer-Frankiermaschine,

Fig. 1b,     Rückansicht der Thermotransfer-Frankiermaschine,

Fig. 2,     Detail der Luftführung mit Sicherheitsgehäuseteil, Z-Variante,

Fig. 3,     Ausschnitt der Unterschale des Sicherheitsgehäuses und Sicherheitsgehäuseteil vor dessen Montage,

Fig. 4,     Ausschnitt der Unterschale und Sicherheitsgehäuseteil nach dessen Montage,

Fig. 5,     Detail der Luftführung mit Sicherheitsgehäuseteil, L-Variante,

Fig. 6,     Detail der Luftführung mit Sicherheitsgehäuseteil, B-Variante,

Fig. 7,     Detail der Luftführung mit Sicherheitsgehäuseteil, ⊔-Variante,

Fig. 8,     Detail der Luftführung mit Sicherheitsgehäuseteil, H-Variante,

Fig. 9,     Seitenansicht der Thermotransfer-Frankiermaschine.

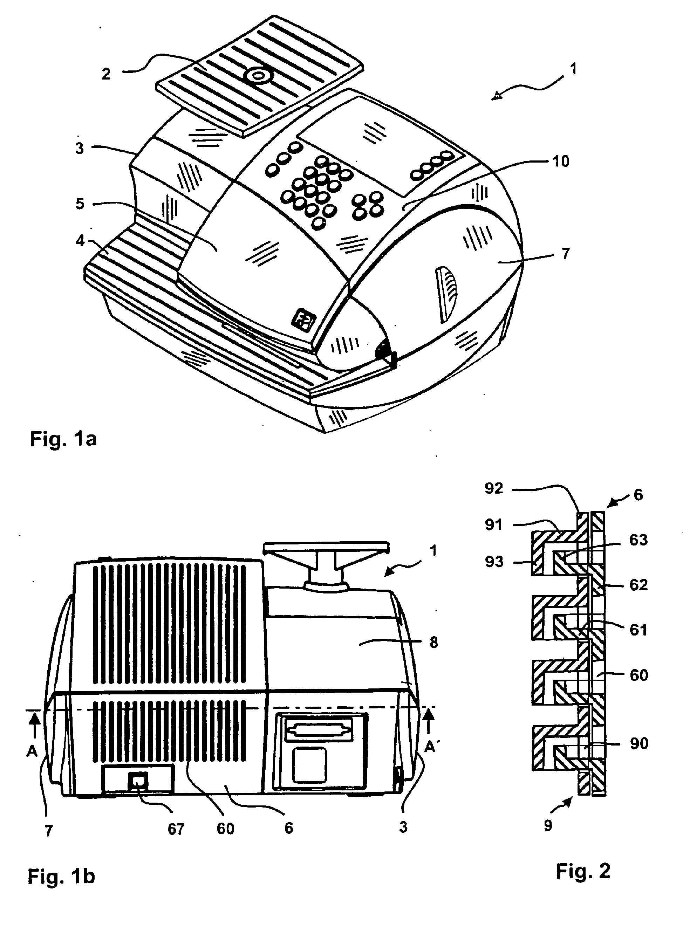

Die Fig. 1a zeigt eine perspektivische Ansicht von vorn und rechts oben einer Thermotransfer-Frankiermaschine 1 der nächsten Generation. Die Thermotransfer-Frankiermaschine 1 ist an deren rechten Seitenwand 7 des Sicherheitsgehäuses und an deren Oberteil 10 mit einer Klappe 5 zum Kassettenfach der Frankiermaschine 1 und an deren linken Seite mit einem Wiegeteller 2 einer Waagebaugruppe ausgestattet. An die — durch die Ansicht verdeckte - linke Seitenwand 3 des Sicherheitsgehäuses der Frankiermaschine kann ein - nicht gezeigter - manueller Briefschließer beigestellt werden. Die Zu- und Abführung eines Poststückes erfolgt auf dem Zuführtisch 4 der Frankiermaschine an der Vorderseite der Frankiermaschine 1 von links nach rechts. Alle Gehäuseteile sind zum Beispiel aus farbigem Kunststoff hergestellt.

Die Fig. 1b zeigt eine Rückansicht der Thermotransfer-Frankiermaschine 1 mit den Seitenwänden 3, 7 und der Rückwand 6, 8 des Sicherheitsgehäuses. Auf der Außenseite der Rückwand 6 einer Sicherheitsgehäuseunterschale sind Lüftungsöffnungen 60 zur Zuführung von Luft und weitere Öffnungen, wie beispielsweise für einen Modemanschluss 67, sichtbar. Auf der Außenseite der Rückwand 8 einer Sicherheitsgehäuseoberschale sind Lüftungsöffnungen zur Abführung von erwärmter Luft sichtbar. Die Lüftungsöffnungen 60 zur Zuführung von Luft werden durch eine Linie A-A' geschnitten in der Figur 2 dargestellt.

Die Fig. 2 zeigt ein Detail der Luftführung mit Sicherheitsgehäuseteil 9 und mit der Rückwand 6 einer Sicherheitsgehäuseunterschale, welche beide durch die Linie A-A' geschnitten im Querschnitt dargestellt werden. Die Rippen sind mit Ihrer Rippenbasis 62 auf der Innenseite der Rückwand 6 der Sicherheitsgehäuseunterschalte angeformt und bestehen im Querschnitt aus einem Rippensteg 61 zwischen der Rippenbasis 62 und einem Rippenkopf 63, wobei die Rippenbasis 62 zu jeder benachbarten Rippenbasis so beabstandet ist, dass dadurch die erste Luftführungsöffnung 60 entsteht. Das nahe an der Innenseite des Sicherheitsgehäuses angeordnete Sicherheitsgehäuseteil 9 weist angeformte Hauben auf, welche die Rippen überdecken. Die Hauben an dem Sicherheitsgehäuseteil 9 bestehen im Querschnitt aus einem Haubensteg 91 zwischen einer Haubenbasis 92 und einem Haubendach 93, wobei die Haubenbasis 92 zu jeder benachbarten Haubenbasis so beabstandet ist, dass dadurch eine zweite Luftführungsöffnung 90 entsteht. Durch die Formung der Hauben in Z-Form bei Draufsicht auf den Querschnitt durch den oberen Rand der Rückwand 6 der Sicherheitsgehäuseunterschale (bzw. Fig. 2 nach links gedreht betrachtet) und Formung der Rippen im Querschnitt ähnlich einer am Rand gespiegelten Z-Form wird im Ergebnis ihrer Anordnung zueinander ein Eindringen von einem Werkzeug den Innenraum verhindert, obwohl die beiden Öffnungen 60 und 90 übereinander liegen.

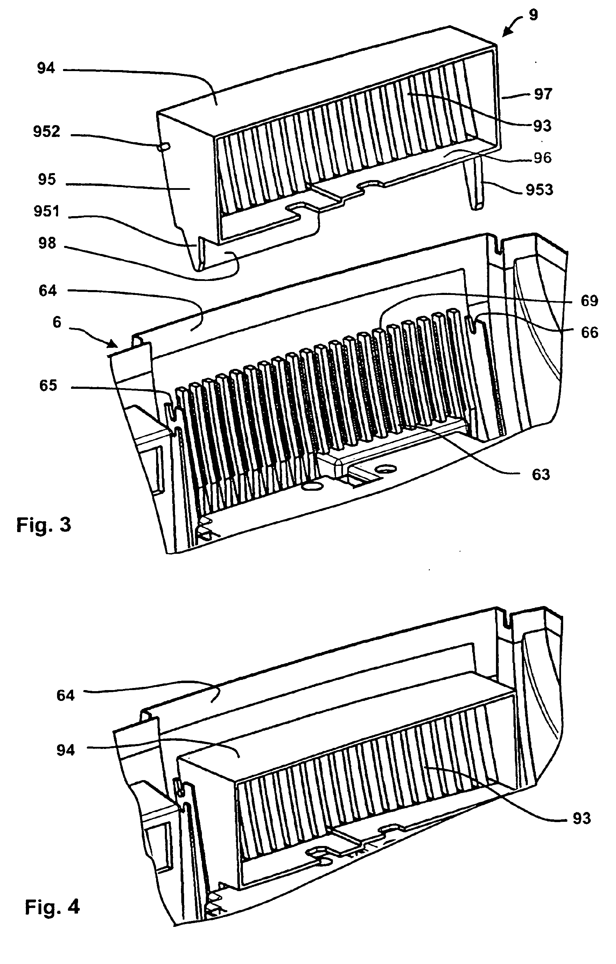

In der Fig. 3 wird ein Ausschnitt der Rückwand 6 einer Unterschale des Sicherheitsgehäuses und das Sicherheitsgehäuseteil 9 vor dessen Montage in der Perspektive von vorn links und oben dargestellt. In den senkrecht oder in einem Winkel dazu ausgerichteten Rippen befinden sich jeweils seitlich eine Öffnung, die an ihrem nach oben und unten weisenden Ende durch mindestens eine Seitenwand 69 verschlossen und zum Innenraum gerichtet durch den Rippenkopf 63 überdacht ist. Mit dem entfernt gezeichneten aber zusätzlich anordenbaren Sicherheitsgehäuseteil 9 lässt sich ein Eindringen den Innenraum (Sicherheitsbereich) verhindern. Das Sicherheitsgehäuseteil hat Hauben mit einem Haubendach 93, das geeignet geformt ist, um einen Rippenkopf zu überdecken. In den Hauben befinden sich — hier nicht sichtbare nach rechtsgerichtete - Öffnungen, durch welche die Luft von Außen in den Innenraum zum Sicherheitsbereich strömen kann. Das Sicherheitsgehäuseteil 9 ist so geformt, dass sich ein Kanal ergibt, welcher den Luftstrom direkt an die Wärmequelle im Sicherheitsbereich auf der Leiterplatte leitet. Das Sicherheitsgehäuseteil ist zum Beispiel kastenförmig geformt, mit einem Oberteil 94, linken Seitenteil 95 , Unterteil 96 und rechten Seitenteil 97, wobei sich ein linkes bzw. rechtes Führungsteil 951 bzw. 953 am linken bzw. rechten Seitenteil 95, 97 von dem Unterteil 96 nach unten erstreckt. Außerdem kann sich eine Rückwand 98 des Sicherheitsgehäuseteils 9 von dem Unterteil 96 nach unten erstrecken. An den Seitenteilen 95, 97 ist je ein Aufnahmestift 952, 972 angeordnet, der mit einer zugehörigen Aufnahme 65, 66 form-schlüssig zusammenpasst.

Die Fig. 4 zeigt den Ausschnitt der Unterschale und Sicherheitsgehäuseteil nach dessen Montage. Das auf der Innenseite 64 im Innenraum angebrachte Sicherheitsgehäuseteil besitzt mindestens ein Oberteil 94 und Hauben, deren Haubendach 93 über den Rippen so angeordnet ist, das ein Eindringen in den Innenraum (Sicherheitsbereich) ohne nachweisbare Beschädigung des Sicherheitsgehäuses unmöglich ist.
Alternativ kann das Sicherheitsgehäuseteil abweichend von der recheckigen Kastenform geformt sein, wobei sich aber wieder ein im Querschnitt dann zum Beispiel ovaler, kreisförmiger, dreieckiger oder trapezförmiger Kanal ergibt, welcher den Luftstrom direkt an die Wärmequelle im Sicherheitsbereich auf der Leiterplatte leitet.
Wenn auch die in der Figur 2 (Z-Variante) gezeigten ersten als auch zweiten Luftführungselemente im Querschnitt als z-förmig gebogene Hauben bzw. als an der Rückwand 6 gespiegelte z-förmige Rippen, dargestellt worden sind, soll das keine Einschränkung in der Formgebung der Luftführungselemente bedeuten.

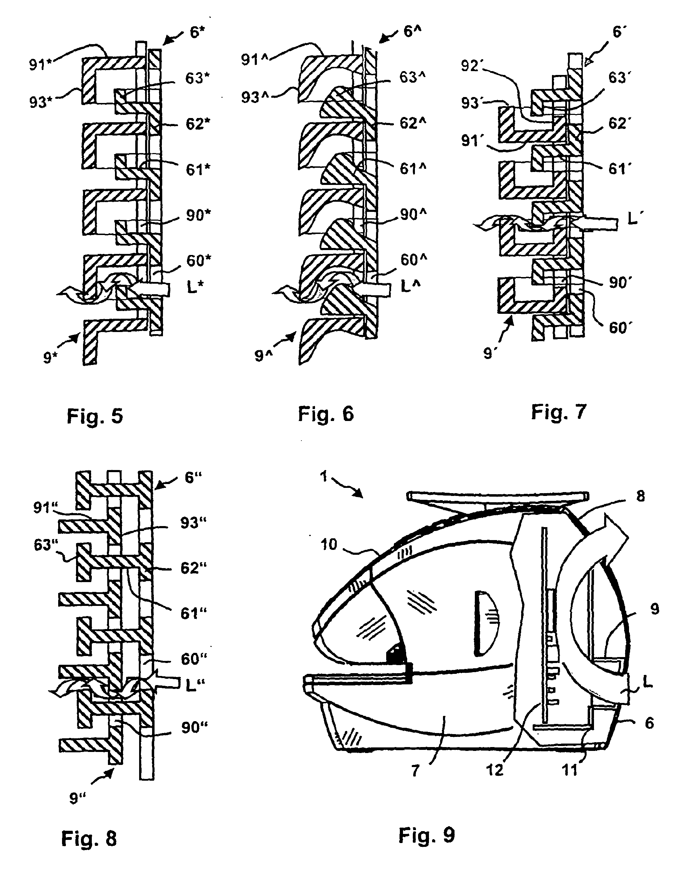

In der Fig. 5 ist ein Detail der Luftführung mit Sicherheitsgehäuseteil einer alternativen L-Variante gezeigt, wobei die Hauben bei Draufsicht auf den Rand der Rückwand 6 der Sicherheitsgehäuseunterschale (bzw. Fig. 5 nach links gedreht betrachtet) eine L-Form im Querschnitt aufweisen und die Rippen die am oberen Rand gespiegelte Z-Form im Querschnitt beibehalten. Die auf der Innenseite der Sicherheitsgehäuseunterschalte 6* angeformten Rippen bestehen aus dem Rippensteg 61* zwischen der Rippenbasis 62* und dem Rippenkopf 63*, wobei die Rippenbasis 62* zu jeder benachbarten Rippenbasis so beabstandet ist, dass dadurch die erste Öffnung 60* entsteht. Das nahe an der Innenseite des Sicherheitsgehäuses angeordnete Sicherheitsgehäuseteil 9* weist angeformte Hauben auf, welche die Rippen überdecken. Die Hauben an dem Sicherheitsgehäuseteil 9* bestehen jeweils aus einem Haubensteg 91* und Haubendach 93*, welche im Querschnitt L-förmig verbunden sind, wobei zwischen benachbarten Rippenstegen 61* und Haubenstegen 91* jeweils eine zweite Öffnung 90* entsteht.

Alternativ können in einer weiteren - nicht gezeigten - Variante auch die Rippen eine ⌐-Form (seitlich gespiegelte L-Form) und Hauben eine L-Form im Querschnitt aufweisen.

In der Fig. 6 ist ein Detail der Luftführung mit Sicherheitsgehäuseteil einer alternativen B-Variante gezeigt, wobei beide Luftführungselemente im Querschnitt stromlinienförmig ausgebildet sind, d.h. wobei die aus Haubensteg 91^ und Haubendach 93^ bestehenden Hauben eine Bogenform (B-Form) sowie die aus Rippensteg 61^, Rippenbasis 62^ und Rippenkopf 63^ bestehenden Rippen eine gerundete Form für aufweisen. Zwischen Rippenbasis und benachbarten Rippenbasis 62^ existiert jeweils eine erste Luftführungsöffnung 60^ und zwischen benachbarten Rippenstegen 61^ und Haubenstegen 91^ existiert jeweils eine zweite Luftführungsöffnung 90^.

In der Fig. 7 ist ein Detail der Luftführung mit Sicherheitsgehäuseteil einer alternativen ⊔-Variante gezeigt, wobei beide Luftführungselemente rechtwinklig geformt ausgebildet sind, d.h. wobei die Hauben bei Draufsicht auf die Figur 7 von eine

⊔

-Form aufweisen. Bei Draufsicht auf den Rand der Rückwand 6 der Sicherheitsgehäuseunterschale (bzw. einer um 90° nach links gedrehten Ansicht der Figur 7) haben die Hauben eine ⊐-Form und die Rippen eine Z-Form. Auch diese Variante mit rechtwinkligen Luftführungselementen 61', 62', 63'und 91', 92', 93' kann strömungsmäßig verbessert werden, indem alle Ecken und Kanten abgerundet geformt werden. Auf diese Weise wird beispielsweise - in nicht gezeigter Weise - aus der

⊔-Form eine U-Form (bei Ansicht der Figur 7) oder eine ⌐-Form (bei Draufsicht auf den Rand der Rückwand 6). Alternativ kann statt der Ansicht nach Figur 7 auch eine V-Form (nicht gezeigt) für die Hauben verwendet werden.

Eine weitere - in der Figur 8 gezeigte - H-Variante für Details der Luftführung mit Sicherheitsgehäuseteil entsteht bei der Nutzung einer symmetrischen Form der beiden Luftführungselemente 61", 62", 63" und 91", 92", 93". Bei Draufsicht auf die Figur 8 haben die Rippen eine H-Form und die Hauben die Form eines liegenden T. Mit anderen Worten, bei Draufsicht auf den Rand der Rückwand 6 der Sicherheitsgehäuseunterschale (bzw. einer um 90° nach links gedrehten Ansicht der Figur 8) haben die Rippen eine I-Form und die Hauben eine T-Form.

Auch diese Variante mit rechtwinkligen Luftführungselementen 61", 62", 63" und 91", 92", 93" kann strömungsmäßig zu einer - nicht gezeigten - Stromlinienvariante verbessert werden, indem alle Ecken und Kanten abgerundet geformt werden. Dann haben die Hauben eine Tropfen-Form und die Rippen die Form einer liegenden Sanduhr.

In der Fig. 9 ist eine Thermotransfer-Frankiermaschine 1 in Seitenansicht von rechts dargestellt worden, wobei vom Oberteil 10 der Oberschale bis zur Unterschale des Sicherheitsgehäuses die rechte Seitenwand 7 an der hinteren Kante aufgeschnitten gezeichnet wurde, um die Luftführung L zu verdeutlichen. Über Lüftungsöffnungen in der Rückwand 6 der Unterschale des Sicherheitsgehäuses wird Luft zugeführt und über Lüftungsöffnungen in der Rückwand 8 der Oberschale des Sicherheitsgehäuses wird erwärmte Luft nach außen abgeführt. Das Sicherheitsgehäuseteil 9 bildet einen Kanal zur gezielten Luftzuführung an eine Leiterplatte 12 mit elektronischen Bauelementen und verhindert zugleich einen Zugang von außen an die elektronischen Bauelemente durch einen gekrümmten Luftzuführweg. Im Inneren kann ein weiterer Kanal durch Chassisteile 11 zur gezielten Zu- und Abführung von Luft gebildet werden. Die erwärmte Luft ist leichter als kühle Luft und steigt auf. Dabei wird kühlere Luft über den Kanal angesaugt. Da das Gerät Konvektion von Luft zur Wärmeabführung von der Wärmequelle benutzt, kommt es ohne Lüfter aus. Wenn die Erfindung auch nur anhand von einer Frankiermaschine erläutert wurde, soll aber dadurch ein Einsatz in anderen Geräten nicht ausgeschlossen werden. Diese Geräte können auch kreisrunde oder anders geformte längs-, schräg- oder querliegende Lüftungsöffnungen aufweisen, wobei nur das Sicherheitsgehäuseteil 9 entsprechend angepasst werden muss. Wesentlich ist aber, dass in den durch jede Lüftungsöffnung freigegebenen Luftweg zwei Luftführungselemente ragen, die von den gegenüberliegenden oder nebeneinanderliegenden Seiten der Lüftungsöffnung ausgehend sich gegenseitig überdecken, wobei ein erstes Luftführungselement auf der Innenseite des Sicherheitsgehäuses und ein zweites Luftführungselement auf der Innenseite des Sicherheitsgehäuseteils angeformt sind. Das Sicherheitsgehäuseteil 9 ist vorteilhaft im Spritzgußverfahren aus Kunststoff oder Metall herstellbar. Die eckigen Varianten können auch aus Metallblech gestanzt werden.

Somit können offensichtlich weitere andere Ausführungen der Erfindung entwickelt bzw. eingesetzt werden, die vom gleichen Grundgedanken der Erfindung ausgehen und von den anliegenden Ansprüchen umfasst werden.

Liste der verwendeten Bezugszeichen:

| 1 | Thermotransfer-Frankiermaschine |
| 2 | Wiegeteller |
| 3 | linke Seitenwand des Sicherheitsgehäuses der Frankiermaschine |
| 4 | Zuführtisch der Frankiermaschine |
| 5 | Klappe des Kassettenfachs |
| 6 | Rückwand einer Sicherheitsgehäuseunterschale |
| 60 | Schlitz-Öffnung in der Sicherheitsgehäuserückwand |
| 61 | Steg einer Rippe |
| 62 | Basis einer Rippe |
| 63 | Kopf einer Rippe |
| 64 | Innenseite der Sicherheitsgehäuserückwand |
| 65, 66 | Aufnahme für Sicherheitsgehäuseteil, |
| 67 | Modemanschluss, |
| 68 | - |
| 69 | Seitenwand, |
| 7 | rechte Seitenwand des Sicherheitsgehäuses der Frankiermaschine |
| 8 | Rückwand einer Sicherheitsgehäuseoberschale |
| 9 | Sicherheitsgehäuseteil (innen) |
| 90 | Schlitz-Öffnung in Rückwand des Sicherheitsgehäuseteils, |
| 91 | Haubensteg |
| 92 | Haubenbasis |
| 93 | Haubendach |
| 94 | Oberteil des Sicherheitsgehäuseteils, |
| 95 | Linkes Seitenteil des Sicherheitsgehäuseteils, |
| 951 | linkes Führungsteil, |
| 952 | Aufnahmestift, |
| 953 | rechtes Führungsteil, |
| 96 | Unterteil des Sicherheitsgehäuseteils, |
| 97 | Rechtes Seitenteil des Sicherheitsgehäuseteils, |
| 972 | Aufnahmestift, |
| 98 | Rückwand des Sicherheitsgehäuseteils, |
| 99 | - |
| 10 | Gehäuseoberteil |
| 11 | Chassisteil |
| 12 | Leiterplatte |

**Patentansprüche**

1. Sicherheitsgehäuse mit Lüftungsöffnungen zur Luftzuführung an eine Wärmequelle im Innenraum eines Gerätes, in welchem eine Konvektion von Luft zur Wärmeabführung von der Wärmequelle erfolgt, wobei erste Luftführungselemente auf der Innenseite des Sicherheitsgehäuses an wenigstens einer ersten Seite jeder der Lüftungsöffnungen angeordnet und so geformt sind, dass letztere wenigstens teilweise überdeckt werden, **gekennzeichnet dadurch, dass** die ersten Luftführungselemente auf der Innenseite des Sicherheitsgehäuses mit ihrer Basis angeformt sind, wobei die Basis zu jeder benachbarten Basis so beabstandet ist, dass dadurch jeweils eine der Luftführungsöffnungen (60) entsteht, dass die ersten Luftführungselemente Rippen sind, die jeweils im Querschnitt eine Rippenbasis (62), einen Rippensteg (61) und einen Rippenkopf (63) zur Luftführung in eine von einer geradlinigen Luftführung abweichenden ersten Richtung aufweisen, dass ein entfernbares Sicherheitsgehäuseteil im Innenraum des Gerätes angeordnet ist und einen Luftführungskanal bildet, dass das Sicherheitsgehäuseteil mit zweiten Luftführungselementen ausgestattet ist, wobei die zweiten Luftführungselemente in den Innenraum des Luftführungskanals gerichtet und so geformt sind, dass sie die ersten Lüftungsöffnungen (60) des Sicherheitsgehäuses und die ersten Luftführungselemente wenigstens soweit überdecken, dass im Bereich der ersten und zweiten Luftführungselemente eine ungeradlinige Luftführung gewährleistet wird.

2. Sicherheitsgehäuse, nach Anspruch 1, **gekennzeichnet dadurch, dass** die zweiten Luftführungselemente Hauben sind, die jeweils im Querschnitt mindestens einen Haubensteg (91) und ein Haubendach (93) zur Luftführung in eine von einer geradlinigen Luftführung abweichenden zweiten Richtung aufweisen, wobei die zweite Richtung entgegengesetzt zur ersten Richtung verläuft.

3. Sicherheitsgehäuse, nach den Ansprüchen 1 und 2, **gekennzeichnet dadurch, dass** der Rippensteg (61) zwischen Rippenbasis (62) und dem Rippenkopf (63) angeordnet ist, wobei die Rippe im Querschnitt eine Form aufweist, die der am Rand der Rückwand (6) gespiegelten Z-Form ähnlich ist und dass der Haubensteg (91) zwischen einer Haubenbasis (92) und dem Haubendach (93) angeordnet ist, wobei die Haube eine der Z-Form ähnliche Form bei Draufsicht auf den Rand des Sicherheitsgehäuses aufweist.

4. Sicherheitsgehäuse, nach den Ansprüchen 1 und 2, **gekennzeichnet dadurch, dass** der Rippensteg (61') zwischen Rippenbasis (62') und dem Rippenkopf (63') angeordnet ist, wobei die Rippe im Querschnitt eine der Z-Form ähnliche Form aufweist und dass der Haubensteg (91') zwischen einer Haubenbasis (92') und dem Haubendach (93') angeordnet ist, wobei die Haube eine der J-Form ähnliche Form bei Draufsicht auf den Rand des Sicherheitsgehäuses aufweist.

5. Sicherheitsgehäuse, nach den Ansprüchen 1 und 2, **gekennzeichnet dadurch, dass** der Rippensteg (61*) zwischen Rippenbasis (62*) und dem Rippenkopf (63*) angeordnet ist, wobei die Rippe im Querschnitt eine Form aufweist, die der am Rand des Sicherheitsgehäuses gespiegelten Z-Form ähnlich ist und dass der Haubensteg (91*) zwischen einer Haubenbasis (92*) und dem Haubendach (93*) angeordnet ist, wobei die Haube eine der L-Form ähnliche Form bei Draufsicht auf den Rand des Sicherheitsgehäuses aufweist.

6. Sicherheitsgehäuse, nach den Ansprüchen 1 bis 5, **gekennzeichnet dadurch, dass** im Querschnitt eine symmetrische Form für Rippen (61 ", 62", 63") und Hauben (91", 92", 93") vorgesehen wird.

7. Sicherheitsgehäuse, nach den Ansprüchen 1 bis 6, **gekennzeichnet dadurch, dass** die Ecken und Kanten gerundet sind und im Querschnitt eine strömungsgünstige Form für Rippen und Hauben vorgesehen wird.

8. Sicherheitsgehäuse, nach Anspruch 1, **gekennzeichnet dadurch, dass** die ersten Luftführungselemente auf der Innenseite einer Rückwand (6) des Sicherheitsgehäuses einer Frankiermaschine (1) angeformt sind und dass die zweiten Luftführungselemente jeweils ein Elementeteil aufweisen, welches an einer jeweils der vorgenannten ersten Seite jeder der ersten Lüftungsöffnungen (60) gegenüberliegenden zweiten Seite im Abstand so angeordnet sind, so dass dadurch jeweils zweite Luftführungsöffnungen (90) entstehen sowie dass das entfernbare Sicherheitsgehäuseteil so im Innenraum angeordnet ist, dass die ersten Lüftungsöffnungen (60) in der Rückwand (6) und zweiten Luftführungsöffnungen (90) übereinanderliegen.

9. Sicherheitsgehäuse, nach den Ansprüchen 1 und 8, **gekennzeichnet dadurch, dass** das Elementeteil die Haubenbasis (92, 92', 92") ist.

10. Sicherheitsgehäuse, nach den Ansprüchen 1 und 8, **gekennzeichnet dadurch, dass** das Elementeteil der Haubensteg (91*, 91^) ist.

**Claims**

1. A security housing having vent openings for air supply to a heat source inside an appliance in which a convection of air takes place for removing heat from the heat source, wherein first air-conduction elements are arranged on the inside of the security housing on at least a first side of each of the vent openings and are shaped in such a manner that the latter are covered at least in part, **characterized in that** the basis of the first air-conduction elements is formed onto the inside of the security housing, the basis being distanced from each adjacent basis in such a manner that they form that way one of the vent openings (60) each; that the first air-conduction elements are ribs the cross section of which shows a rib basis (62), a rib web (61) and a rib head (63) for air conduction in a first direction diverging from a straight-line air conduction; that a removable part of the security housing is arranged inside the appliance and forms an air-conduction channel; that the part of the security housing is provided with second air-conduction elements, said second air-conduction elements being directed into the interior of the air-conduction channel and shaped in such a manner that they cover the first vent openings (60) of the security housing and the first are-conduction elements at least to such an extent that a non-straight air conduction is ensured in the area of the first and second air-conduction elements.

2. A security housing according to Claim 1, **characterized in that** the second air-conduction elements are hoods the cross section of which shows at least a hood web (91) and a hood roof (93) for air conduction in a second direction diverging from a straight-line air conduction, the second direction being opposite to the first direction.

3. A security housing according to Claims 1 and 2, **characterized in that** the rib web (61) is arranged between rib basis (62) and rib head (63), the cross section of the rib having a form that is similar to a Z-shape mirrored on the edge of the back wall (6) and that the hood web (91) is arranged between a hood basis (92) and the hood roof (93), the hood having a form similar to a Z-shape in a top view of the edge of the security housing.

4. A security housing according to Claims 1 and 2, **characterized in that** the rib web (61') is arranged between rib basis (62') and rib head (63'), the cross section of the rib having a form that is similar to a Z-shape and that the hood web (91') is arranged between a hood basis (92') and the hood roof (93'), the hood having a form similar to a J-shape in a top view of the edge of the security housing.

**5.** A security housing according to Claims 1 and 2, **characterized in that** the rib web (61*) is arranged between rib basis (62*) and rib head (63*), the cross section of the rib having a form that is similar to a Z-shape mirrored on the edge of the security housing and that the hood web (91*) is arranged between a hood basis (92*) and the hood roof (93*), the hood having a form similar to an L-shape in a top view of the edge of the security housing.

**6.** A security housing according to Claims 1 to 5, **characterized in that**, in the cross section, the ribs (61 ", 62", 63") and the hoods (91 ", 92", 93") have a symmetrical form.

**7.** A security housing according to Claims 1 to 6, **characterized in that** the corners and edges are rounded and that, in the cross section, ribs and hoods have a favourable flow form.

**8.** A security housing according to Claim 1, **characterized in that** the first air-conduction elements are formed onto the inside of a back wall (6) of the security housing of a franking machine (1) and that the second air-conduction elements have an element part each that is arranged on a second side opposite to the aforementioned first side of each of the first vent openings (60) spaced in such a manner that they form respective second air-conduction openings (90) and that the removable part of the security housing is arranged in such a manner in the interior that the first vent openings (60) in the back wall (6) and the second air-conduction openings (90) are on top of each other.

**9.** A security housing according to Claims 1 and 8, **characterized in that** the element part is the hood basis (92, 92', 92").

**10.** A security housing according to Claims 1 and 8, **characterized in that** the element part is the hood web (91*, 91^).

**Revendications**

**1.** Boîtier de sécurité doté d'orifices d'aération pour l'admission d'air sur une source de chaleur dans l'intérieur d'un appareil dans lequel s'effectue une convection de l'air afin d'évacuer la chaleur de la source de chaleur, sachant que les premiers éléments de conduite d'air sont disposés sur le côté intérieur du boîtier de sécurité à au moins un premier côté de chacun des orifices d'aération, et façonnés de sorte que ces derniers soient recouverts au moins en partie, **caractérisé en ce que** les premiers éléments de conduite d'air sont appliqués avec leur base sur le côté intérieur du boîtier de sécurité, sachant que la base est placée à un tel intervalle de chaque base voisine, que l'un des orifices de conduite d'air (60) respectifs se crée de ce fait,

**en ce que** les premiers éléments de conduite d'air sont des nervures présentant chacune une base de nervure (62), une âme de nervure (61) et une tête de nervure (63) dans la section transversale pour la conduite d'air dans une première direction déviant d'une conduite d'air rectiligne,

**en ce qu'**une pièce de boîtier de sécurité amovible est disposée dans l'intérieur de l'appareil et constitue un canal de conduite d'air,

**en ce que** la pièce de boîtier de sécurité est équipée de deuxièmes éléments de conduite d'air, sachant que lesdits deuxièmes éléments de conduite d'air sont dirigés dans l'intérieur du canal de conduite d'air et façonnés de sorte qu'ils recouvrent les premiers orifices d'aération (60) du boîtier de sécurité et les premiers éléments de conduite d'air au moins de manière à ce qu'une conduite d'air non rectiligne soit garantie dans la zone des premiers et des deuxièmes éléments de conduite d'air.

**2.** Boîtier de sécurité selon la revendication 1, **caractérisé**
**en ce que** les deuxièmes éléments de conduite d'air sont des capots qui présentent chacun dans la section transversale au moins une béquille de capot (91) et un toit de capot (93) destinés à la conduite d'air dans une deuxième direction déviant d'une conduite d'air rectiligne, sachant que la deuxième direction passe en sens inverse de la première direction.

**3.** Boîtier de sécurité selon les revendications 1 et 2, **caractérisé**
**en ce que** l'âme de nervure (61) est disposée entre la base de nervure (62) et la tête de nervure (62), sachant que la nervure présente dans la section transversale une forme qui est similaire à la forme en Z reflétée sur le bord du dos (6)
et **en ce que** la béquille de capot (91) est disposée entre une base de capot (92) et le toit de capot (93), sachant que le capot présente une forme similaire à la forme en Z lors de la vue de dessus sur le bord du boîtier de sécurité.

**4.** Boîtier de sécurité selon les revendications 1 et 2, **caractérisé**
**en ce que** l'âme de nervure (61') est disposée entre la base de nervure (62') et la tête de nervure (63'), sachant que la nervure présente dans la section transversale une forme qui est similaire à la forme en Z
et **en ce que** la béquille de capot (91') est disposée entre une base de capot (92') et le toit de capot (93'), sachant que le capot présente une forme similaire à la forme en J lors de la vue de dessus sur le bord du boîtier de sécurité.

5. Boîtier de sécurité selon les revendications 1 et 2, **caractérisé**
 **en ce que** l'âme de nervure (61*) est disposée entre la base de nervure (62*) et la tête de nervure (63*), sachant que la nervure présente dans la section transversale une forme qui est similaire à la forme en Z reflétée sur le bord du boîtier de sécurité
 **et en ce que** la béquille de capot (91*) est disposée entre une base de capot (92*) et le toit de capot (93*), sachant que le capot présente une forme similaire à la forme en L lors de la vue de dessus sur le bord du boîtier de sécurité.

6. Boîtier de sécurité selon les revendications 1 à 5, **caractérisé**
 **en ce que**, dans la section transversale, une forme symétrique est prévue pour les nervures (61", 62", 63") et les capots (91", 92", 93").

7. Boîtier de sécurité selon les revendications 1 à 6, **caractérisé**
 **en ce que** les angles et les arêtes sont arrondis et **en ce que** dans la section transversale, une forme favorable à la circulation est prévue pour les nervures et les capots.

8. Boîtier de sécurité selon la revendication 1, **caractérisé en ce que** les premiers éléments de conduite d'air sont appliqués sur le côté intérieur d'un dos (6) du boîtier de sécurité d'une affranchisseuse (1) et **en ce que** les deuxièmes éléments de conduite d'air présentent chacun une pièce d'élément, ladite pièce d'élément étant disposée par intervalle sur le deuxième côté situé face à l'un des premiers côtés précités respectifs de chacun des orifices d'aération (60), de sorte que des deuxièmes orifices de conduite d'air (90) se créent de ce fait et **en ce que** la pièce de boîtier de sécurité amovible est disposée dans l'intérieur de sorte que les premiers orifices d'aération (60) dans le dos (6) et les deuxièmes orifices de conduite d'air (90) soient situés les uns au-dessus des autres.

9. Boîtier de sécurité selon les revendications 1 et 8, **caractérisé en ce que** la pièce d'élément est la base du capot (92, 92', 92").

10. Boîtier de sécurité selon les revendications 1 et 8, **caractérisé en ce que** la pièce d'élément est la béquille du capot (91*, 91^).

**Fig. 1a**

**Fig. 1b**

**Fig. 2**

94

952

95

951

98

64

6

65

9

97

93

96

953

69

66

63

**Fig. 3**

64

94

93

**Fig. 4**

Fig. 5

Fig. 6

Fig. 7

Fig. 8

Fig. 9